# EUROPEAN PATENT APPLICATION

(11) **EP 1 467 459 A1**
(43) Date of publication of application: **13.10.2004**
(21) Application number: 03100987.1
(22) Date of filing: 11.04.2003
(51) Int. Cl.: H02H 5/04

(54) **Method and apparatus for integrated circuit protection**

(71) Applicant: Koninklijke Philips Electronics N.V., 5621 BA Eindhoven (NL)
(72) Inventor: The designation of the inventor has not yet been filed
(74) Representative: Slenders, Petrus Johannes Waltherus

(57) **Abstract**

A method and apparatus for protecting an integrated circuit against damage caused by excessive temperatures, the integrated circuit comprising a plurality of power transistors (208a, 208b,....., 208n). Each of the power transistors (208) is provided with a respective temperature measurement circuit (200a, 200b,...... ,200n). Temperature measurement is based on the temperature dependence of the current through a reverse biased pn-junction. All temperature measurement circuits (200) are connected to a pull-down line (202), the trigger input of a timer (204). The timer (204) generates a pulse with a fixed period that is fed to a shutdown circuit (206) that switches off all of the power transistors (208) by pulling base to emitter and disabling all their driver transistors, in the event that the temperature in any one of the power transistors (208) is determined to exceed some predetermined local threshold temperature. A global temperature sensor (210) is also provided to measure temperature of the small signal part of the integrated circuit, and switch off the circuit in the event that this temperature is determined to exceed some predetermined global threshold temperature.

## Description

This invention relates to a method and apparatus for protection of integrated circuits, and more particularly, but not necessarily exclusively, to a method and apparatus for protection of audio integrated circuits and the like against damage due to excessive temperatures.

Excessive temperatures can permanently damage integrated circuit devices. An integrated circuit, such as an audio power integrated circuit, designed to deliver high output power can generate sufficient self-heating to reach these critical temperatures. This can occur due to short circuits, low ohmic load, heat sink absence, etc. In order to prevent damage under these conditions, a protection circuit is required, which usually comprises an internal circuit arranged to shut down the integrated circuit when a maximum temperature is reached.

A conventional global temperature protection circuit tends to respond to a single temperature measured somewhere on the silicon die. For example, in US Patent No. 4,667,265 an example of such a global protection circuit is described in which temperature measurements are based on the leakage current of a reverse-biased pn junction. However, an integrated circuit for high output power contains multiple large output transistors and, because of delays and the error in measurement result caused by the (varying) distances from each of the transistors to the point at which temperature is measured, this method is not usually fast enough or accurate enough to protect the integrated circuit against excessive temperatures in the power transistors that may lead to permanent damage.

In order to prevent such damage in the power transistors, dissipation in the transistor tends to be measured and limited to a maximum, even if the transistor temperature is still far below critical level. This means that the output power of the product is artificially and unnecessarily limited, and a larger power transistor would be required to reach a higher output power specification.

Other commercially-available integrated circuits instead employ local temperature measurement in each power transistor with the aid of a sense emitter (for example, as described in US Patent No. 4,669,026). This local temperature measurement is used to reduce the current gain of the power transistor when it exceeds a certain threshold temperature. A further increase in base current is compensated with a decrease in current gain so that the output current (and the power dissipation) no longer responds to the drive current and the temperature is maintained around the threshold value.

A major advantage of this method is that it prevents the unnecessary output power limitation mentioned above. The sense-emitter is located as close to the power generating area as possible (preferably in the middle of a power transistor) which gives the lowest possible error and delay in the temperature measurement. The transistor fully exploits the dynamic safe operating area. However, one significant disadvantage of this method is that the current source connected to the sense emitter needs a certain voltage for proper operation. For the low side power transistor, this means that the power emitter cannot be connected directly to ground, but instead requires the provision of a resistance between emitter and ground. This results in an unwanted reduction in maximum output power, particularly in respect of low supply voltages.

Another disadvantage of this method is that a large capacitor is required to provide stability to the temperature control loop for each power transistor. The 20pF capacitor referred to in US Patent No. 4,669,026 corresponds to a significant proportion (20%) of the power transistor area itself. Yet another disadvantage of this method arises from the use of a transistor in an overall feedback loop in the sense that, when the feedback loop tries to force a certain output current out of the integrated circuit by increasing the drive current to the power transistor, the local feedback loop tends to counteract this by reducing the current gain of the power transistor by discarding part of the drive current. The result of this is that the driver stage will clip to its maximum drive current.

We have now devised an improved arrangement.

In accordance with the present invention, there is provided a method of protecting an integrated circuit against damage due to excessive temperatures, the integrated circuit comprising two or more transistors, the method comprising the steps of:
i) measuring temperature in each of said transistors; and
ii) if the measured temperature in any of said transistors exceeds a first predetermined threshold temperature, disabling at least one of said transistors for a predetermined period of time;
the method being characterized in that the temperature measurement is performed by measurement of current through a reverse biased diode provided in respect of each of said transistors.

Also in accordance with the present invention, there is provided apparatus for protecting an integrated circuit against damage due to excessive temperatures, the integrated circuit comprising two or more transistors, the apparatus comprising:
i) means for measuring temperature in each of said transistors; and
ii) means for disabling at least one of said transistors for a predetermined period of time if the measured temperature in any of said transistors exceeds a predetermined threshold temperature;
the apparatus being characterized in that the means for measuring temperature comprises means for measuring current through a reverse biased diode provided in respect of each of said transistors.

The present invention further extends to an integrated circuit comprising a plurality of power transistors, and apparatus for protecting said integrated circuit against damage due to excessive temperatures as defined above.

The present invention extends still further to a method of manufacturing an integrated circuit comprising two or more transistors, the method including the steps of providing, in respect of each of said transistors, a reverse biased diode, means for monitoring current through each of said reverse biased diodes to determine the temperature of the respective transistors, and providing means for disabling one or more of said transistors in the event that the temperature of any of said transistors is determined to exceed a predetermined threshold temperature.

Thus, the present invention provides a method and apparatus for protecting an integrated circuit from damage due to excessive temperature, which is exclusively based on temperature measurements in the power transistors. The dissipation is not limited (peaks up to 250 Watts per channel, in accordance with one embodiment of the invention). The integrated circuit only shuts down (for a predetermined period of time, say 3.5ms) when unacceptable temperatures are reached. This maximizes the output power of the integrated circuit (e.g. an amplifier) and protects against:
the absence of an external heat sink;
a short circuit of output to the supply voltage pin;
a short circuit of output to ground pin;
a short circuit across the load (SE or BTL)
a very low ohmic load.

The approach employed in accordance with the present invention reduces the design of the protection circuit to a fast local temperature measurement inside a power transistor, a timer circuit and a shutdown circuit to switch off the power transistors.

Beneficially, means are provided for effecting a global temperature measurement in the small signal part of the integrated circuit, in addition to the local temperature measurements effected in each of the respective transistors. Such temperature measurement is preferably also based on current through a reverse biased pn junction provided in the small signal part of the integrated circuit. The system is beneficially arranged to switch all of the transistors off in the event that the temperature in any of the transistors or the small signal part of the integrated circuit is determined to be grater than some predetermined threshold temperature, for example 185°C in the power transistors, and 150°C in the small signal part of the integrated circuit. A timer is beneficially provided for causing the transistors to be switched back on after a predetermined period of time, say 3.5ms, after they have been switched off.

In a preferred embodiment, a single timer and shut down circuit are provided in respect of all of the temperature measuring means, which significantly decreases the integrated circuit area.

The method and apparatus of the present invention are particularly, but not exclusively, suited for use in audio amplifiers and the like.

Thus, in summary, the present invention relates to a novel method and circuitry for the protection of power transistors, such as those found in power or audio amplifiers for example. According to the present invention, protection is achieved by indirectly measuring, at a number of different locations, the temperature of the power transistor(s) by means of the leakage current of a reverse biased diode. In an exemplary bipolar process, the junction between an N-type epitaxial layer and a P-type substrate of a tub, in which a lateral PNP transistor is made, forms this diode. The leakage current may act as a base current for the PNP transistor and is directly amplified by the PNP transistor in an exemplary embodiment. The amplified leakage current is compared to a threshold current. The result is used to drive a NPN transistor that activates a timer circuit that is used to "time out" the power transistor. The threshold current and the current mirror can be adjusted so that the "trigger" temperature can also be adjusted. Preferably, the temperature sensor and a "signal", i.e. power, amplifier are all integrated into a single component.

Advantages of the present invention include:
Greater power output
No unnecessary audio holes
Operating principle is not dependent to:
Supply voltage
Load impedance
Heat sink size
ower dissipation
Power transistor size
Die attach quality
Package type
Ambient temperature
Output current

These and other aspects of the invention will be apparent from, and elucidated with reference to the embodiments described hereinafter.

Embodiments of the present invention will now be described by way of examples only and with reference to the accompanying drawings, in which:
Figure 1 is circuit diagram representative of a measurement and trigger circuit according to an exemplary embodiment of the present invention;
Figures 2 to 4 are plan views of a power transistor structure according to an exemplary embodiment of the present invention, with isolated island in the middle containing the lateral PNP transistor;
Figure 5 is a schematic cross-sectional view of the power transistor structure according to an exemplary embodiment of the present invention (two transistor fmgers and PNP-transistor) from left to right; and
Figure 6 is a schematic representation of a thermal protection method according to an exemplary embodiment of the present invention.

In an exemplary embodiment of the present invention, a protection method is provided which is based on nine temperature measurements on the die surface of an integrated circuit. Eight local measurements are effected substantially in the middle of each of eight power transistors and one global temperature measurement is effected in the small signal part of the integrated circuit. If one of these temperatures is determined to exceed a maximum value (say 185°C in the power transistors, and 150°C in the small signal part of the integrated circuit), a timer is activated that switches off all power transistors for predetermined period of time, in this case, 3.5ms. During this time, the product cools down. After the predetermined period of time has elapsed, the power transistors are enabled again. If there is still a high dissipation condition present, the temperature will increase again until the critical level is reached and the power transistors are switched off again.

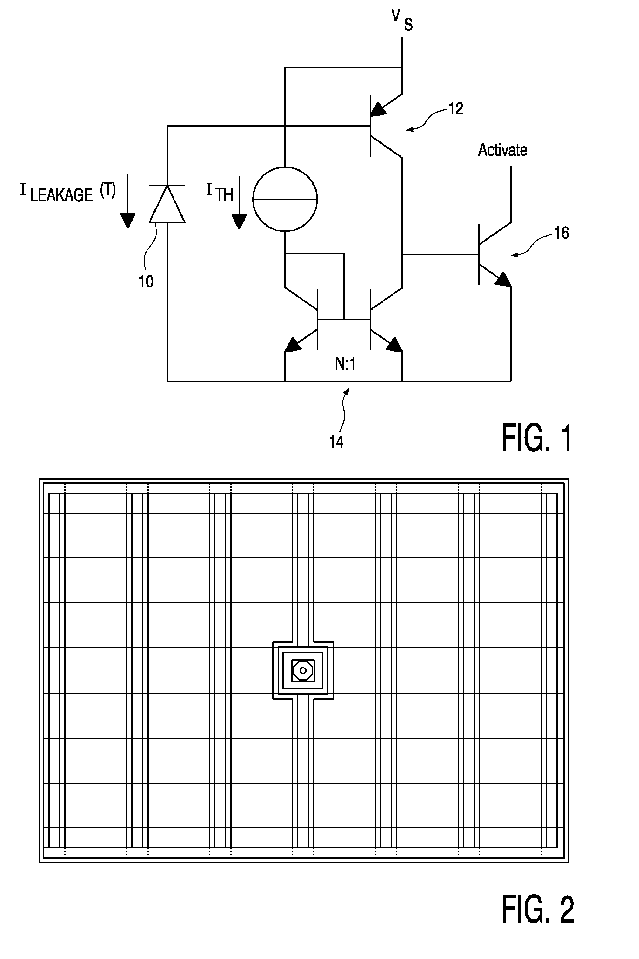

Referring to Figure 1 of the drawings, temperature measurement is based on the temperature dependence of the current through a reverse biased pn- junction 10 with anode connected to the P-type substrate and the cathode connected to base of a lateral PNP transistor whose emitter is connected to a supply voltage (Vₛ). The junction between N-type epitaxial layer and the P-type substrate of a tub in which a lateral PNP transistor is made forms the diode (10). The leakage current (I Leakage) acts as a base current for the PNP 2 and is directly amplified to the collector of this PNP. This way the temperature sensor and a signal amplifier are all integrated in a single component which is very area efficient. The amplified leakage current is compared to a threshold current with the aid of a current mirror 14 with ratio 1:N. The result is used to drive a NPN transistor 16 that pulls down the ACTIVATE node for activation of the timer. With the threshold current and the current mirror ratio N the trigger temperature can be adjusted. To make sure that there is only a minimum difference between the temperature of lateral PNP 12 and actual power transistor temperature, the PNP 12 is embedded within the power transistor.

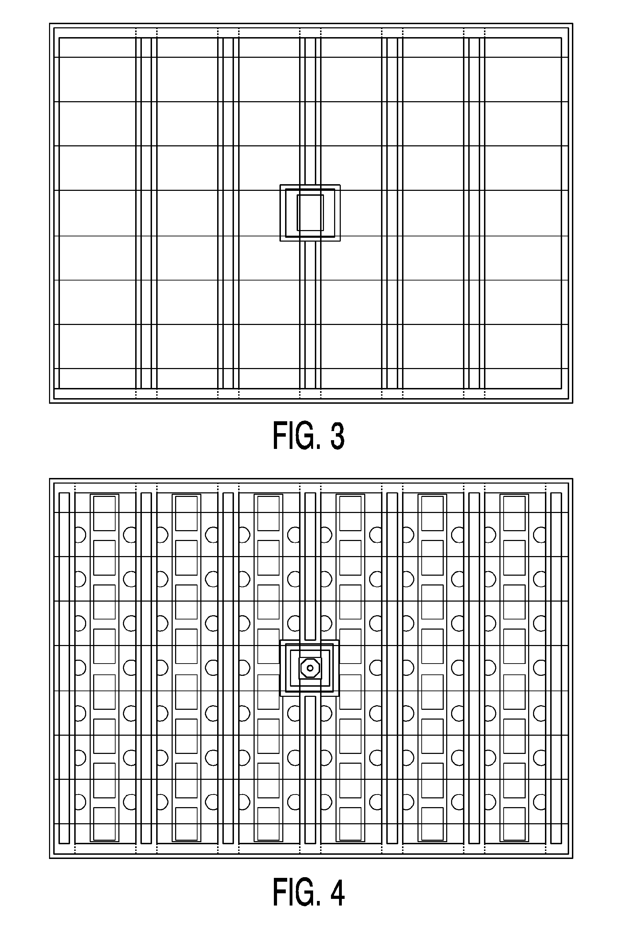

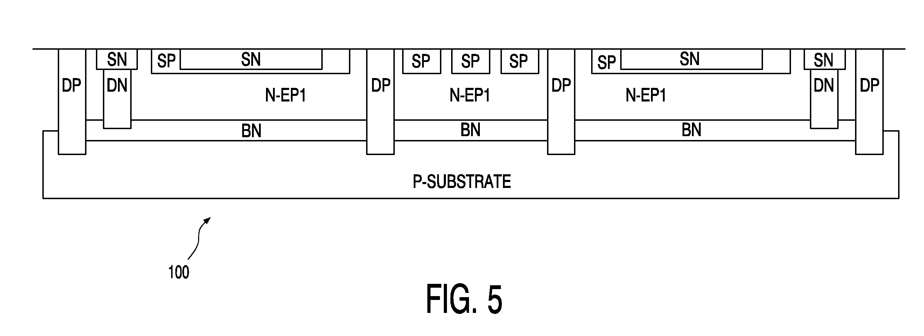

In order to minimize the delay and the error in the local temperature measurement, the reverse biased diode 10 should be located as close to the heat generating area as possible. A first demand is that the power transistor structure ensures a homogeneous current distribution, also at high power dissipation levels, so that the highest temperature occurs in the middle of the power transistor. There, the reverse biased pn-junction should ideally be placed. In one exemplary embodiment of the invention is realized with a junction-isolated island containing a lateral PNP transistor in the middle of the power transistor. The power transistor is built up with several emitter and collector fingers. The isolated island is placed in the middle of a collector fmger so that loss in active emitter area is minimal. Furthermore, this ensures that the island is surrounded with active, heat generating, transistor area. Referring to Figure 5 of the drawings the power transistor 100 may be made in a standard bipolar process with a shallow P diffusion (SP) as a base, a shallow N diffusion (SN) as emitter, a N-epitaxial layer as collector with a Buried N layer (BN) and a plug with Deep N (DN) and SN for a low ohmic collector contact. Isolation is done with a deep P diffusion (DP) to the P-substrate. In the emitter area H-shaped holes are created to form a distributed emitter resistance for homogeneous current distribution. The top view of the transistor layout is shown in Figures 2, 3 and 4 of the drawings.

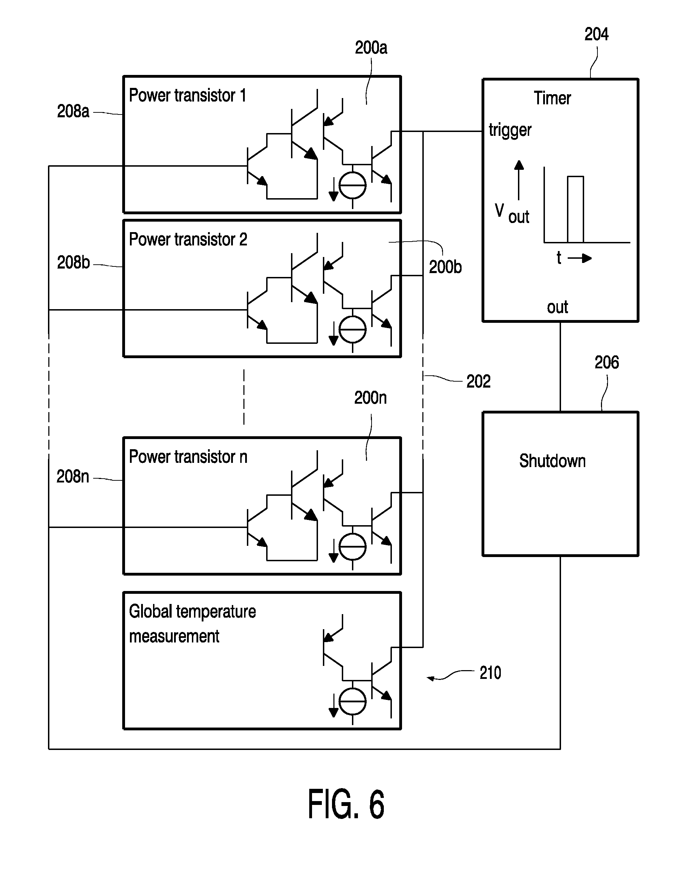

In Figure 6 of the drawings the protection method is shown schematically. All temperature measurement circuits 200a, b..... are connected to a pull-down line 202, the trigger input of the timer 204. This timer generates a pulse with a fixed period that is fed to a shutdown circuit 206 that switches off all power transistors 208a, b..... (by pulling base to emitter) and all their driver transistors. The global temperature sensor 210 is almost identical to the local sensors, only the threshold current I_{threshold.global} (and consequently the threshold temperature) is lower.

The location of the temperature sensor in the small signal part of the circuit is at such a distance from the power transistors that its temperature is very close to the heat sink temperature under normal operating conditions. The maximum junction temperature for the small signal part of the circuit is, in this exemplary embodiment of the invention, 150°C according to the General Quality Specifications (GQS).

Thus, in summary, most conventional protection methods try to prevent all possible events which may lead to high temperatures, such as short circuits, low ohmic load, the absence of a heat sink, etc. However, the actual temperature rise due to all of these conditions is dependent on many parameters (ambient temperature, length of the dissipation pulse, power transistors size, die attach quality, external heat sink size, supply voltage, etc.). Because of the margins and ranges of all of these parameters, the output power of the product is by defmition artificially limited to a value much lower than it can handle. For example, when a protection is based on a maximum power dissipation of 50W during 10ms, this means that the protection is unnecessarily activated for 50W pulses of 1ms (while the temperature rise during these short pulses would still be acceptable). Another solution might be the use of temperature hysteresis. However, because of the good thermal coupling between sensor and power transistor, this results in relatively high switching frequencies (of the order of a few hundred kilohertz) which is not considered acceptable.

In contrast, the protection method of the present invention protects the power transistors from the actual cause of failure, i.e. critically high temperatures. It is therefore unnecessary to specify minimum load impedance, heat sink size, etc. because the product will be automatically protected when the operating conditions are too harsh. In other words, for the activation of the protection circuit of the present invention, the cause of the high (local or global) temperature is not relevant. It can be due to:
the absence of an external heat sink;
a short circuit of output to supply voltage;
a short circuit of output to ground;
a short circuit across the load;
high output current levels into a very low ohmic load;
a large phase shift between output current and output voltage (as in actual speakers) causing high dissipation peaks.

All of these conditions may result in high power transistor temperatures and may trigger the protection mechanism. Note that the protection circuit is only activated when necessary, so even during a short circuit condition, a certain amount of (pulsed) current will still be flowing through the short, just as much as the power transistor can handle without exceeding the critical temperature level.

Embodiments of the present invention have been described herein by way of examples only, and it will be apparent to a person skilled in the art that modifications and variations can be made to the described embodiments without departing from the scope of the invention, as defined by the appended claims. It will also be appreciated that the term "comprising" used herein does not exclude other elements or steps, "a" or "an" does exclude a plurality, and a single processor or other unit may fulfil the functions of several means recited in the claims.

The use of a single timer and shut-down circuit triggered by any one of a plurality of temperature measurements, obviates the need for local control loops with large capacitors, stability risks and clipping driver stages. This results in a significant reduction in chip area and complexity, especially in the case of an integrated circuit having a large number of power transistors.

## Claims

1. A method of protecting an integrated circuit against damage due to excessive temperatures, the integrated circuit comprising two or more transistors, (208) the method comprising the steps of:
i) providing temperature measurement means (200) in or on each of said transistors (208); and
ii) if the measured temperature in any of said transistors (208) exceeds a first predetermined threshold temperature, disabling at least one of said transistors (208) for a predetermined period of time;
the method being **characterized in that** the temperature measurement means (200) comprises means for measuring current through a reverse biased diode (10) provided in respect of each of said transistors (208).

2. A method according to claim 1, wherein said transistors (208) are power transistors.

3. A method according to claim 1 or claim 2, wherein said reverse biased diode (10) is comprises a reverse biased pn junction in said integrated circuit.

4. A method according to any one of claims 1 to 3, including the step of providing temperature measurement means (210) in respect of the small signal part of the integrated circuit, and if the measured temperature of said small signal part of the integrated circuit exceeds a second predetermined threshold temperature, disabling said transistors (208) for a predetermined period of time.

5. A method according to claim 4, wherein said temperature measurement means (210) provided in respect of said small signal part of the integrated circuit comprises means for measuring current through a reverse biased diode.

6. A method according to claim 4, wherein said first predetermined threshold temperature is greater than said second predetermined threshold temperature.

7. A method according to any one of claims 1 to 6, wherein said first and second predetermined threshold temperatures are in the range 130° - 200°C.

8. A method according to any one of claims 1 to 7, wherein said predetermined period of time is in the range 2 to 5 ms, and the method includes the step of automatically enabling the transistors (208) when said predetermined period of time has elapsed.

9. Apparatus for protecting an integrated circuit against damage due to excessive temperatures, the integrated circuit comprising two or more transistors (208), the apparatus comprising:
i) means (200) for measuring temperature in each of said transistors (208); and
ii) means (204,206) for disabling at least one of said transistors (208) for a predetermined period of time if the measured temperature in any of said transistors (208) exceeds a predetermined threshold temperature;
the apparatus being **characterized in that** the means (200) for measuring temperature comprises means for measuring current through a reverse biased diode (10) provided in respect of each of said transistors (208).

10. Apparatus according to claim 9, including means (210) for measuring temperature in the small signal part of the integrated circuit.

11. Apparatus according to claim 10, wherein said means (210) for measuring temperature in the small signal part of the integrated circuit comprises means for measuring current through reverse biased diode.

12. Apparatus according to any one of claims 9 to 11, wherein said transistors (208) are power transistors.

13. Apparatus according to any one of claims 9 to 12, comprising shut-off means (206) for disabling all of said transistors in the event that the temperature in any of said transistors is determined to exceed said predetermined threshold temperature.

14. Apparatus according to claim 13, comprising timer means (204) for causing said transistors (208) to be enabled when said predetermined period of time has elapsed.

15. Apparatus according to any one of claims 9 to 14, wherein said reverse biased diode (10) comprises a reverse biased pn junction provided in said integrated circuit.

16. An integrated circuit comprising a plurality of power transistors (208), and apparatus for protecting said integrated circuit against damage due to excessive temperatures according to any one of claims 9 to 15, said apparatus comprising means (200) for measuring temperature in each of said transistors (208) and a common shut-off (206) and timer means (204) for disabling all of said transistors (208) in the event that the temperature in any one of said transistors (208) is determined to exceed a predetermined threshold temperature and reenabling said transistors when said predetermined period of time has elapsed.

17. An amplifier including an integrated circuit according to claim 16.

18. A method of manufacturing an integrated circuit comprising two or more transistors (208), the method including the steps of providing, in respect of each of said transistors (208), a reverse biased diode (10), means for monitoring current through each of said diodes (10) to determine the temperature of respective transistors (208), and providing means (204,206) for disabling, for a predetermined period of time, one or more of said transistors (208) in the event that the temperature of any of said transistors (208) is determined to exceed a predetermined threshold temperature.
